# FASCICULE DE BREVET EUROPEEN

(11) **EP 2 729 974 B1**
(45) Date de publication et mention de la délivrance du brevet: **12.08.2015**
(21) Numéro de dépôt: 12745569.9
(22) Date de dépôt: 04.07.2012
(51) Int. Cl.: H01L 51/52, H01L 51/56, H01L 51/00

(54) **DISPOSITIF OPTOELECTRONIQUE ORGANIQUE ET SON PROCEDE D'ENCAPSULATION**
ORGANISCHE OPTOELEKTRONISCHE VORRICHTUNG UND VERKAPSELUNGSVERFAHREN DAFÜR
ORGANIC OPTOELECTRONIC DEVICE AND METHOD FOR THE ENCAPSULATION THEREOF

(30) Priorité: 08.07.2011 FR 1156224
(43) Date de publication de la demande: 14.05.2014
(73) Titulaire: Commissariat à l'Énergie Atomique et aux Énergies Alternatives, 75015 Paris (FR)
(72) Inventeur: MAINDRON, Tony, F-38000 Grenoble (FR); KANAAN, Hani, F-38130 Grenoble (FR)
(74) Mandataire: Bolinches, Michel Jean-Marie
(86) Numéro de dépôt international: PCT/IB2012/053410
(87) Numéro de publication internationale: WO 2013/008143

(56) Documents cités:
- WO-A1-01/39287
- JP-A- 2000 040 594
- US-A1- 2006 061 272
- US-A1- 2006 246 620
- US-A1- 2010 087 032

## Description

La présente invention concerne un dispositif optoélectronique organique, tel qu'un micro-afficheur à diodes électroluminescentes organiques (« OLED »), qui est protégé de l'air ambiant par une encapsulation étanche de type incluant au moins une couche mince, et un procédé d'encapsulation d'un tel dispositif. L'invention s'applique à des unités électroluminescentes de type hybride.

De manière connue, les dispositifs optoélectroniques organiques, tels que les « OLED », nécessitent d'être encapsulés, pour assurer la protection de leurs composants sensibles contre les espèces gazeuses de l'atmosphère (principalement l'oxygène et la vapeur d'eau). En effet, si cette protection n'est pas convenablement réalisée, il risque de se produire une dégradation ultérieure du dispositif qui se manifeste principalement par l'apparition de points noirs non émissifs dans le cas des « OLED », qui sont en fait la résultante de la pénétration de la vapeur d'eau dans la diode, ce qui dégrade l'interface cathode (ou anode) / film(s) organique(s).

Cette encapsulation peut être typiquement réalisée grâce à l'utilisation d'un capot de verre collé sur le dispositif organique à l'aide d'une colle spécifique présentant notamment une faible perméabilité à l'eau. En général, on ajoute un absorbeur d'humidité solide ou « getter » entre le substrat et le capot pour prolonger la durée de vie du dispositif.

Pour certaines applications mais aussi pour une question de réduction de coût, on a développé des couches minces à effet de barrière dont le rôle, par similitude à cet ensemble capot-getter, est de protéger le dispositif sous-jacent de l'agression de l'humidité. D'une manière générale, ces couches barrières sont des oxydes, des nitrures ou des oxynitrures ou, dans certains cas, il peut s'agir de couches minces métalliques sauf si l'unité électroluminescente émet par le sommet de la structure (« top émission » en anglais) auquel cas les couches barrières doivent être transparentes.

Ces couches minces d'encapsulation présentent typiquement une épaisseur totale inférieure à 1 µm, et elles sont déposées par des procédés standards de dépôt sous vide tels que le dépôt chimique en phase vapeur (« CVD ») éventuellement assisté par plasma (« PECVD »), le dépôt de couche atomique (« ALD », parfois appelée « AL-CVD ») ou par des procédés de dépôt physique en phase vapeur (« PVD ») incluant l'évaporation et la pulvérisation. Il est difficile d'envisager pour ces couches minces d'encapsulation d'autres types de dépôts moins coûteux en temps comme le dépôt en phase liquide, car ce type de dépôt nécessite l'utilisation de solutions polymériques contenant des solvants susceptibles de dissoudre les couches de l'unité électroluminescente sous-jacente.

Spécifiquement pour des unités « OLED » hybrides, i.e. dont l'empilement de films organiques d'intercalation entre les électrodes comprend parmi ses films actifs les plus internes un ou plusieurs films déposé(s) par voie liquide (typiquement à la tournette ou « spin-coating » en anglais) pour une maîtrise plus simple de dépôt que celle inhérente aux techniques d'impression, se pose le problème de la localisation précise de ces films qui est très importante pour la réalisation d'un grand nombre de micro-écrans sur une tranche de silicium. En effet, ces films tels que des films de transfert d'électrons (« ETL » pour « electron transport layer »), d'injection de trous (« HIL » pour hole injection layer ») et de transfert de trous (« HTL » pour « houle transport layer »), sont déposés par voie liquide sur tout le substrat (i.e. à pleine surface de la tranche de silicium) et ne peuvent donc être précisément localisés (i.e. confinés à l'unité « OLED ») à moins d'effectuer par la suite une photolithographie, laquelle est malheureusement peu envisageable en raison de la fragilité des composants des unités « OLED » vis-à-vis d'une gravure. Or, on sait que ces films déposés par voie liquide, s'ils ne sont pas ultérieurement confinés à la zone active du microécran correspondant, vont pénaliser la qualité de l'encapsulation de l'unité « OLED » du fait qu'ils forment une voie d'entrée latérale pour la vapeur d'eau de l'atmosphère ambiante dans l'unité « OLED » par perméation et que l'encapsulation déposée sur ces films n'y adhérera pas de manière satisfaisante.

Le document WO-A1-2009/101299 au nom de la Demanderesse divulgue l'utilisation dans une encapsulation à couches minces d'un dispositif optoélectronique organique, d'une couche continue réactive à l'humidité et à base d'un complexe organométallique tel que le tris-(8-hydroxyquinoléinate) d'aluminium III (Alq3), et d'une couche barrière la surmontant pouvant être constituée d'un oxyde choisi parmi ceux répondant aux formules Al₂O₃, SiO₂, SiₓN_{y} ou SiOₓN_{y}.

Le document US-A-2006/0061272 présente à sa figure 3 un dispositif optoélectronique qui comprend une couche barrière par exemple à base d'un monoxyde de silicium recouvrant une couche tampon par exemple à base d'Alq3. La couche tampon surmonte une électrode externe et un empilement de films organiques émetteur de lumière, et la couche barrière est surmontée d'une encapsulation à deux couches inorganiques et est latéralement espacée de l'empilement de films sur cette figure, à droite par la couche tampon et à gauche par l'électrode externe et cette couche tampon.

Le document WO01/39287 décrit un dispositif organique électroluminescent dans lequel une couche de monoxyde de silicium est utilisée comme couche de protection et masque pour structurer une couche organique du dispositif.

Le document US2010/0087032 décrit un dispositif organique dans lequel une couche organique comprenant un complexe métallique est utilisée comme couche de protection et masque de gravure.

Un but de la présente invention est de proposer un dispositif optoélectronique organique tel qu'un micro-afficheur à diodes électroluminescentes organiques, qui permette de remédier aux inconvénients précités, ce dispositif comprenant :
- un substrat,
- au moins une unité électroluminescente déposée sur ce substrat et incorporant une électrode interne adjacente au substrat, une électrode externe transparente ou semi-transparente à la lumière émise par l'unité et définissant une zone active d'émission lumineuse et, entre ces électrodes, un empilement de films organiques, et
- une structure d'encapsulation étanche à couche(s) mince(s) qui comprend au moins une couche inorganique qui surmonte ladite unité électroluminescente en l'enveloppant latéralement,

ce dispositif comprenant en outre une structure de pré-encapsulation qui est localisée entre l'électrode externe et la structure d'encapsulation et qui comprend une couche tampon recouvrant l'électrode externe et à base d'au moins un complexe organométallique hétérocyclique de température de transition vitreuse supérieure à 80° C, et une couche barrière recouvrant cette couche tampon et à base d'un oxyde de silicium de formule SiOₓ, avec x nombre réel spécifiquement tel que 0 < x < 2.

A cet effet, un dispositif selon l'invention est tel que la ou chaque unité électroluminescente est de type hybride, au moins l'un des films actifs dudit empilement qu'elle comporte, de préférence le(s) plus interne(s) formant par exemple au moins un film de transfert d'électrons (« ETL »), un film d'injection de trous (« HIL ») et/ou un film de transfert de trous (« HTL »), étant déposé par voie liquide sur tout le substrat puis structuré par une gravure sèche de sorte que ce(s) film(s) structuré(s) se termine(nt) latéralement sensiblement au droit d'un bord périphérique de la couche barrière.

Cette structure de pré-encapsulation selon l'invention forme avantageusement un masque dur apte à résister à cette gravure sèche, laquelle est par exemple mise en oeuvre par un plasma d'oxygène ou par gravure ionique réactive (« RIE »), en protégeant ainsi les composants sensibles de la ou de chaque unité électroluminescente lors de la structuration de ce(s) film(s) actif(s) déposé(s) par voie liquide. Cette pré-encapsulation autorise ainsi une gravure sèche de la surface du substrat recouverte de ces films déposés par voie liquide sans dégradation des composants de l'unité électroluminescente, pour structurer ces films de sorte à les confiner au droit de la ou de chaque zone active du dispositif (i.e. en enlevant par cette gravure leur portion débordant de la ou de chaque unité électroluminescente).

On notera que la structure de pré-encapsulation obtenue par le dépôt de ces couches tampon et barrière permet notamment de passiver de manière satisfaisante la ou chaque unité électroluminescente et d'augmenter la durée de vie du dispositif.

On notera également que cette structure de pré-encapsulation permet de planariser de manière satisfaisante la surface destinée à recevoir ladite couche inorganique d'encapsulation, en homogénéisant la densité surfacique en groupements -OH de la couche barrière pour assurer une croissance homogène sur cette dernière de cette couche inorganique.

De préférence, ledit oxyde de silicium de formule SiOₓ de la couche barrière est tel que x est sensiblement égal à 1, cette couche barrière étant déposée par évaporation thermique non réactive.

On notera que cette sélection d'un oxyde de silicium proche d'un monoxyde de silicium (de formule SiO) pour la couche barrière procure un effet de synergie en combinaison avec ce complexe organométallique choisi pour la couche tampon, permettant notamment d'optimiser la passivation précitée pour la ou chaque unité électroluminescente et d'obtenir pour cette couche barrière un compromis satisfaisant entre une transparence maximisée dans le domaine visible et une porosité au contraire minimisée.

Selon une autre caractéristique de l'invention, ledit dispositif peut comporter en outre des moyens de liaison électriquement conducteurs qui relient directement un bord périphérique interne de l'électrode externe à un contact électrique de cette dernière prévu dans ledit substrat, et qui traversent le(s)dit(s) film(s) actif(s) le(s) plus interne(s) dudit empilement déposé(s) par voie liquide.

Ces moyens de liaison peuvent avantageusement former un canal métallique annulaire, de préférence à base d'aluminium, sous la forme d'une distribution d'atomes métalliques répartis à travers le(s)dit(s) film(s) actif(s) jusqu'audit contact électrique en forme d'anneau et optionnellement en outre à travers l'électrode externe qui est dans ce cas d'épaisseur inférieure à 20 nm.

On notera que ces moyens de liaison permettent de minimiser la résistance de contact dudit ou desdits film(s) déposé(s) par voie liquide, faiblement conducteur(s) électrique(s) et masquant ledit contact électrique, et d'augmenter en conséquence l'intensité du courant dans la diode.

De manière générale, ladite couche tampon peut avantageusement présenter une épaisseur comprise entre 10 nm et 200 nm, par exemple entre 50 nm et 150 nm.

De préférence, ledit complexe organométallique de la couche tampon est dérivé de la quinoléine ou de la benzoquinoléine et peut avantageusement présenter une température de transition vitreuse supérieure à 80° C, voire à 100° C. A titre encore plus préférentiel, ce complexe organométallique est le tris-(8-hydroxyquinoléinate) d'aluminium III (Alq3).

Selon une autre caractéristique préférentielle de l'invention, ladite couche tampon présente une surface d'aire au moins égale à celle de ladite électrode externe, laquelle est de préférence constituée d'une cathode en argent, et ladite couche barrière présente une surface d'aire au moins égale à celle de la couche tampon.

Avantageusement, la couche barrière peut déborder latéralement autour de la couche tampon qui déborde latéralement autour de l'électrode externe, lesdites couches tampon et barrière pouvant s'étendre toutes deux continûment à partir de films internes dudit empilement de films.

Selon une autre caractéristique de l'invention, ladite structure d'encapsulation peut comprendre une dite couche inorganique, ou couche inorganique interne, qui est déposée sur ladite couche barrière de pré-encapsulation par dépôt de couche atomique (« ALD ») ou par dépôt chimique en phase vapeur assisté par plasma (« PECVD »), qui est à base d'au moins un composé inorganique choisi dans le groupe constitué par les composés de formule AlₓO_{y}, SiOₓ, SiₓN_{y}, SiOₓN_{y}, ZnSe, Sb₂O₃ et les oxydes transparents conducteurs (OTC) optionnellement combinés à un métal, et qui est de préférence à base d'Al₂O₃ déposé par « ALD », cette couche inorganique interne s'étendant à partir du substrat en enrobant latéralement ladite couche barrière et plusieurs desdits films organiques dudit empilement.

Selon un mode préférentiel de réalisation de l'invention, ladite structure d'encapsulation comprend également :
- au moins une couche polymérique photosensible gravée qui est de préférence à base d'une résine positive de photolithographie et qui recouvre ladite couche inorganique interne de manière latéralement enveloppante en s'étendant à partir du substrat, et
- une autre dite couche inorganique, ou couche inorganique externe, qui est par exemple à base du même composé que ladite couche inorganique interne et qui recouvre de manière latéralement enveloppante cette couche polymérique photosensible, de sorte à former une pluralité de surfaces parallèles entre elles et sensiblement perpendiculaires au plan du substrat qui forment autant d'obstacles à la pénétration latérale de vapeur d'eau vers ladite ou chaque zone active du dispositif.

Par « résine positive », on entend de manière connue une résine qui se polymérise lors de son dépôt, les parties insolées au rayonnement sélectivement à travers un masque étant dépolymérisées puis dissoutes lors du développement. En variante, cette résine peut être négative (i.e. sa zone insolée se polymérise et devient ainsi insoluble lors du développement).

Un procédé d'encapsulation selon l'invention d'un dispositif tel que défini ci-dessus comprend les étapes successives suivantes :
a) on dépose ladite couche tampon sur ladite électrode externe de la ou de chaque unité électroluminescente, la couche tampon étant de préférence à base d'un complexe organométallique dérivé de la quinoléine ou de la benzoquinoléine de température de transition vitreuse supérieure à 100° C tel que le tris-(8-hydroxyquinoléinate) d'aluminium III (Alq3),
b) on dépose par évaporation thermique non réactive ladite couche barrière sur cette couche tampon, cette couche barrière étant à base d'un oxyde de formule SiOₓ avec de préférence x sensiblement égal à 1 et enrobant latéralement cette couche tampon,
c) on transfère optionnellement la ou chaque unité électroluminescente recouverte de ces couches tampon et barrière en vue de son encapsulation, directement à l'atmosphère ambiante sans la confiner dans une enceinte de transfert telle qu'une boîte à gants,
d) on soumet à une gravure sèche, par exemple mise en oeuvre par un plasma d'oxygène ou par gravure ionique réactive (« RIE »), la ou chaque unité électroluminescente recouverte de ces couches tampon et barrière, puis
e) on dépose sur cette couche barrière une dite couche inorganique de ladite structure d'encapsulation, ou couche inorganique interne, par dépôt de couche atomique (« ALD ») ou par dépôt chimique en phase vapeur assisté par plasma (« PECVD »), cette couche inorganique interne étant à base d'au moins un composé inorganique choisi dans le groupe constitué par les composés de formule AlₓO_{y}, SiOₓ, SiₓN_{y}, SiOₓN_{y}, ZnSe, Sb₂O₃ et les oxydes transparents conducteurs (OTC) optionnellement combinés à un métal, et qui est de préférence à base d'Al₂O₃ déposé par « ALD », de telle sorte que cette couche inorganique interne s'étende à partir du substrat en enrobant latéralement la couche barrière et le(s)dit(s) films (s) le(s) plus interne(s) dudit empilement.

L'étape d) de gravure sèche peut permettre de structurer l'un au moins des films actifs les plus internes dudit empilement de cette unité dans le cas où il a été déposé par voie liquide sur tout le substrat de sorte qu'il se termine latéralement sensiblement au droit d'un bord périphérique de ladite couche barrière par enlèvement de la portion dudit au moins un film dépassant latéralement de la couche barrière, ledit au moins un film ainsi structuré formant par exemple un film de transfert d'électrons (« ETL »), un film d'injection de trous (« HIL ») et/ou un film de transfert de trous (« HTL »), ces couches tampon et barrière jouant alors le rôle d'un masque dur lors de cette gravure.

Même si elle ne sert pas à structurer le(s) film(s) actif(s), il est apparu que cette étape de gravure sèche favorise l'étape subséquente e) de dépôt, notamment dans le cas d'un dépôt par « ALD ».

Comme indiqué à l'étape c) ci-dessus, on notera que ce procédé selon l'invention autorise une exposition à l'air ambiant (i.e. un passage directement à l'atmosphère respirable de la salle blanche sans utilisation d'une boîte de transfert usuelle, également appelé « air break » en anglais) de la ou de chaque unité électroluminescente revêtue de la structure de pré-encapsulation en vue de son encapsulation, grâce à cette structure de pré-encapsulation.

Avantageusement, ledit procédé selon l'invention peut comprendre en outre avant l'étape a) précitée un dépôt par pulvérisation localisée d'atomes métalliques de préférence à base d'aluminium à travers le(s)dit(s) film(s) actif(s) le(s) plus interne(s) préalablement déposé(s) par voie liquide, pour que ces atomes se répartissent à travers ce(s)dit(s) film(s) actif(s) en y formant un canal annulaire électriquement conducteur reliant directement un bord périphérique interne de l'électrode externe à un contact électrique de cette dernière prévu dans ledit substrat.

On peut réaliser ce dépôt par pulvérisation localisée au moyen d'un masque perforé (« shadow mask » en anglais), pour que ledit canal soit de forme annulaire comme ledit contact électrique de l'électrode externe, cette pulvérisation étant réalisée au choix :
- avant le dépôt de l'électrode externe, directement sur et à travers le(s)dit(s) film(s) actif(s) le(s) plus interne(s) déposé(s) par voie liquide, ou
- après le dépôt de l'électrode externe qui présente alors de préférence une épaisseur inférieure à 20 nm, directement sur et à travers cette électrode externe et ce(s) film(s) actif(s) le(s) plus interne(s).

On notera que le dépôt de ce canal annulaire conducteur est réalisé selon l'invention par une technique « PVD » spécifiquement de pulvérisation, la Demanderesse ayant découvert qu'un dépôt « PVD » par évaporation thermique ne permet pas d'obtenir une pénétration suffisante de ce(s) film(s) actif(s) interne(s) par les atomes métalliques.

Selon ledit mode préférentiel de réalisation de l'invention, ce procédé peut comprendre en outre une étape f) consécutive à l'étape e) où :
f1) on dépose en phase liquide sur ladite couche inorganique interne une couche photosensible par exemple à base d'une résine positive de photolithographie (par toute technique d'enduction comme par exemple à la tournette ou via un revêtement par immersion ou « dip-coating »),
f2) on grave cette couche photosensible ainsi déposée par insolation à des emplacements prédéterminés en la masquant sélectivement des rayonnements d'insolation pour qu'elle soit, d'une part, polymérisée suite à cette insolation au-dessus de ladite couche inorganique interne et en une portion enveloppante enrobant latéralement cette couche inorganique interne à partir du substrat et, d'autre part, dépolymérisée ailleurs, puis
f3) on développe cette couche photosensible polymérisée par trempage dans un bain, optionnellement suivi d'une insolation complémentaire de cette couche photosensible.

On notera que l'étape e) précitée est de préférence mise en oeuvre par « ALD », dépôt réalisable à basse température et permettant d'obtenir une couche inorganique de densité élevée et de perméabilité très réduite qui épouse au plus près les micro- ou nanoreliefs de la surface sous-jacente, et que cette couche inorganique interne déposée par « ALD » permet l'usage à l'étape f) de solvants polaires ou apolaires, e.g. l'éthanol, l'eau, acétone et de solutions de développement/stripping de résines photosensibles tels que celles de dénominations TMAH et ROR.

Avantageusement en référence à ce mode préférentiel de réalisation de l'invention, ce procédé peut comprendre en outre une étape g) consécutive à l'étape f) où l'on dépose sur ladite couche polymérique photosensible une autre dite couche inorganique, ou couche inorganique externe, qui est par exemple à base du même composé que ladite couche inorganique interne et qui recouvre également de manière latéralement enveloppante cette couche polymérique photosensible, de sorte à former une pluralité de surfaces parallèles entre elles et sensiblement perpendiculaires au plan du substrat qui forment autant d'obstacles à la pénétration latérale de vapeur d'eau vers la ou chaque zone active du dispositif.

D'autres avantages, caractéristiques et détails de l'invention ressortiront du complément de description qui va suivre en référence aux dessins annexés, donnés uniquement à titre d'exemples et dans lesquels :
la figure 1 est une vue schématique en coupe transversale d'un dispositif à unité électroluminescente hybride non conforme à l'invention, dont les films organiques déposés par voie liquide n'ont pas été confinés à cette unité entre le dépôt de la pré-encapsulation et celui de l'encapsulation,
la figure 2 est une vue schématique en coupe transversale montrant le résultat d'une première étape de pré-encapsulation d'un dispositif à unité électroluminescente hybride selon l'invention, avant confinement de ces films organiques déposés par voir liquide,
la figure 3 est une vue schématique en coupe transversale illustrant l'action d'une gravure sèche sur le dispositif de la figure 2 pour réaliser ce confinement, avant encapsulation de ce dispositif pré-encapsulé,
la figure 4 est une vue schématique en coupe transversale montrant, d'une part, le résultat de cette gravure sèche avec le confinement de ces films et, d'autre part, le résultat d'une étape ultérieure de dépôt d'une couche inorganique interne d'encapsulation sur cette pré-encapsulation,
la figure 5 est une vue schématique en coupe transversale d'un dispositif selon l'invention finalement obtenu suite aux étapes des figures 2 à 4, montrant deux couches organique et inorganique d'encapsulation ultérieurement déposées sur cette couche inorganique interne,
les figures 6 et 7 sont deux graphiques illustrant la tenue en chambre climatique d'une couche d'Alq3 de 100 nm d'épaisseur déposée sur silicium et encapsulée par une couche de SiO de 25 nm d'épaisseur (figure 6) et de 10 nm d'épaisseur (figure 7), respectivement, montrant pour chacun d'eux l'évolution au cours du temps de stockage de l'intensité de photoluminescence (FL) du film et de la position du pic à l'intensité maximale,
les figures 8 et 9 sont deux graphiques illustrant à titre d'essais comparatifs la tenue en chambre climatique (figure 8) et à l'atmosphère du laboratoire (figure 9), respectivement, d'un film vierge d'Alq3 de 100 nm d'épaisseur déposé sur silicium mais non encapsulé, montrant pour chacun d'eux l'évolution au cours du temps de stockage de l'intensité de photoluminescence (FL) du film et de la position du pic à l'intensité maximale,
la figure 10 est un graphique auquel sont annexés deux clichés obtenus par microscope à force atomique et illustrant la rugosité de surface Rq après 12 h de stockage en chambre climatique, d'un film d'Alq3 vierge de 100 nm d'épaisseur déposé sur silicium (essai témoin correspondant au cliché en haut à gauche) et d'une couche d'Alq3 encapsulée par une couche de SiO (essai de l'invention correspondant au cliché en haut à droite),
la figure 11 est un cliché obtenu par microscopie optique montrant les défauts visibles sous forme de points noirs de la surface d'une « OLED » recouverte à titre d'essai témoin d'une couche d'encapsulation de SiO évaporée après plus de 840 h au laboratoire,
la figure 12 est un cliché obtenu par microscopie optique (image négative montrant beaucoup moins de défauts, ici sous forme de zones surbrillantes) de la surface d'une structure de pré-encapsulation selon l'invention Si/Alq3/SiO après plus de 536 h au laboratoire,
la figure 13 est un graphique à barres illustrant le taux de Q1 parfaites, Q2 parfaites, Q1 à -1% et Q2 à -1%, après 200 h de stockage, pour trois dispositifs « TemaB55 », « TemaB61 » et « TemaB93 »,
la figure 14 est un graphique à trois courbes IV (Q2, t₀) respectivement pour les diodes « TemaA273 » (pré-encapsulée Alq3/SiO selon l'invention avec traitement plasma O₂ et encapsulée Al₂O₃), « TemaB61 » (témoin avec uniquement pré-encapsulation SiO et encapsulation Al₂O₃) et « TemaB74 » (pré-encapsulée SiO et sans encapsulation), montrant comparativement la tenue en Q2 de cette diode de l'invention suite à une exposition à l'air ambiant et à un traitement plasma,
la figure 15 est un graphique illustrant la durée de vie augmentée en termes de luminance L de diodes Q2 selon l'invention (« TemaA273 »), en comparaison de la diode témoin « TemaB61 »,
la figure 16 est une vue schématique en plan illustrant la succession des masques et le caractère enveloppant des couches déposées pour la pré-encapsulation selon l'invention d'une « OLED » sur sa cathode,
la figure 17 est un graphique illustrant des mesures d'ellipsométrie réalisées sur la couche barrière de SiOₓ selon l'invention déposée par évaporation thermique, sous forme de deux courbes de constantes optiques n et k en fonction de la longueur d'onde émise,
la figure 18 est une vue schématique en coupe transversale d'un autre dispositif selon l'invention correspondant à une variante de la figure 4, montrant un canal annulaire électriquement conducteur formé entre la cathode et l'anneau de cathode par un dépôt d'atomes métalliques à travers les films organiques internes déposés par voie liquide,
les figures 19A et 19B sont des vues schématiques partielles en coupe transversale illustrant les distributions d'atomes métalliques obtenues respectivement selon un procédé non conforme à l'invention et conforme à l'invention pour l'obtention du canal de la figure 18 selon un premier exemple de mise en oeuvre de cette variante, en relation pour chacune de ces figures avec une courbe montrant le gradient de cette distribution le long de la direction verticale x du plan de coupe,
les figures 20A et 20B sont des vues similaires aux figures 19A et 19B illustrant les distributions schématiques obtenues respectivement selon un procédé non conforme à l'invention et conforme à l'invention pour l'obtention du canal de la figure 18 selon un second exemple de mise en oeuvre de cette variante, en relation avec une courbe montrant le gradient de cette distribution le long de la direction verticale x du plan de coupe, et
la figure 21 est une vue schématique en plan d'un exemple de masque perforé utilisable pour l'obtention du canal électriquement conducteur de la figure 18.

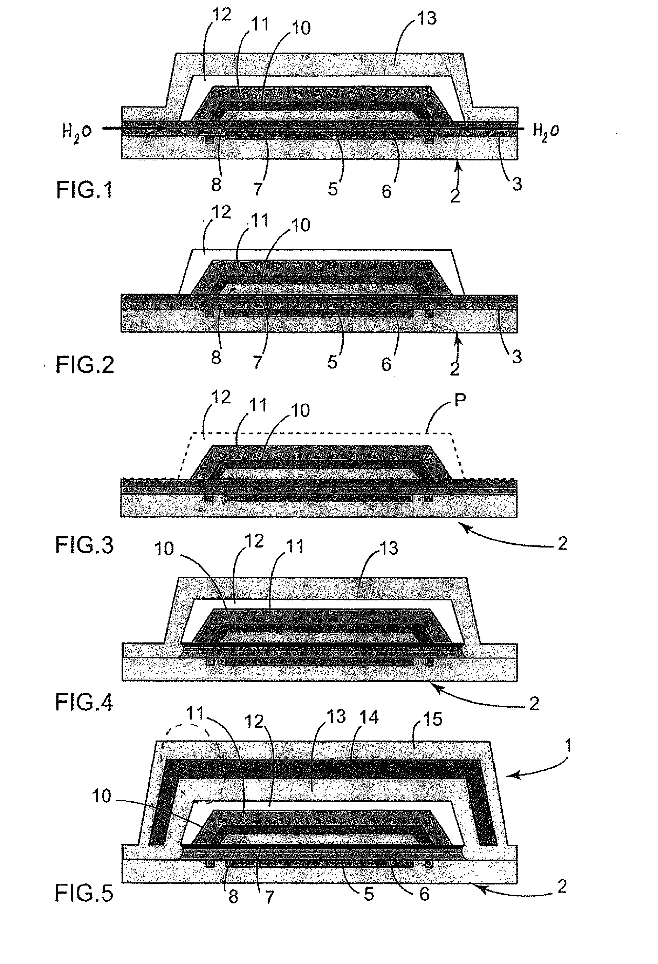

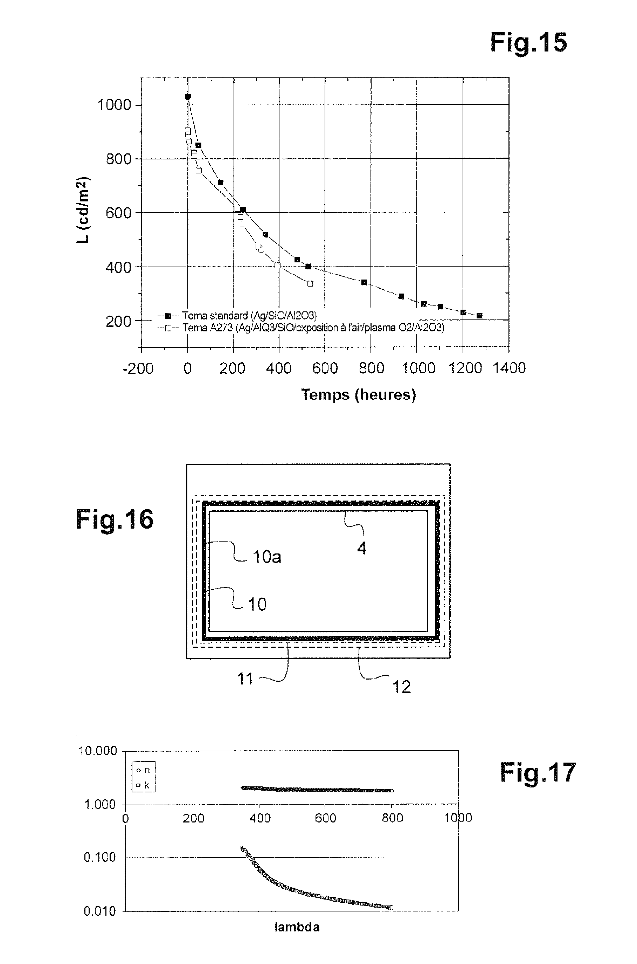

La structure de pré-encapsulation selon l'invention illustrée aux figures 2 et 3 et celle d'encapsulation illustrée aux figures 4 et 5 recouvrent la face d'émission externe d'un dispositif optoélectronique électroluminescent 1 de type « OLED » (représenté à l'état entièrement encapsulé à la figure 5), dont les composants sensibles sont à protéger de l'humidité et de l'oxygène de l'air ambiant. Ce dispositif 1 est par exemple de type microécran « OLED », comprenant un substrat 2 typiquement en silicium revêtu sur sa surface plane 3 d'une unité électroluminescente définissant une zone active centrale 4 (visible à la figure 16) et une zone de connexion électrique (non visible). L'unité comporte une électrode interne 5 (telle qu'une anode) et une électrode externe 10 (telle qu'une cathode) entre lesquelles est intercalée une structure émettrice de lumière à plusieurs films organiques 6, 7, 8 conçus pour transférer les électrons et les trous qui proviennent des électrodes 5 et 10 et qui sont recombinés pour générer des excitons et donc l'émission de lumière, au moins l'électrode externe 10 étant transparente ou semi-transparente à la lumière émise afin de la faire rayonner via la zone active vers l'extérieur du dispositif 1.

Cette électrode externe 10 peut être constituée d'un métal tel que l'argent, l'aluminium ou le samarium - de préférence l'argent - pour les propriétés de transparence de ces métaux dans le domaine visible ainsi que pour leur conductivité électrique à faible épaisseur (l'épaisseur de l'électrode externe 10 est par exemple comprise entre 10 nm et 30 nm).

L'unité électroluminescente illustrée aux figures 1 à 5 est de type hybride, du fait qu'elle comprend parmi les films les plus internes de sa structure émettrice des films actifs 6 et 7 déposés par voie liquide sur toute la surface 3 du substrat 2, par exemple à la tournette. Parmi ces films déposés par voie liquide, on peut par exemple citer un film de transfert d'électrons (« ETL », par exemple de type PEDOT pour poly(3,4 -éthylène dioxythiophène)) et un film de transfert de trous (« HTL », par exemple dopé-p à partir d'une solution), étant précisé qu'un plus grand nombre de films est utilisable.

Dans le dispositif non conforme à l'invention de la figure 1 où ces films déposés par voie liquide demeurent sur toute la surface 3 du substrat 2 après dépôt sur la cathode 10 d'une pré-encapsulation Alq3/SiOₓ (désignée par les couches 11 et 12), elle-même recouverte d'une couche inorganique d'encapsulation 13 en Al₂O₃, l'expérience montre que la vapeur d'eau de l'atmosphère ambiante pénètre latéralement au sein de l'unité « OLED » par perméation à travers ces films 6 et 7 déposés par voie liquide qui débordent de la zone active 4 de cette unité.

Afin de remédier à cet inconvénient, on prévoit selon l'invention de soumettre l'unité « OLED » préalablement recouverte de la structure de pré-encapsulation passivante 11, 12 illustrée à la figure 2 (i.e. formée d'une couche tampon 11 de Alq3 enrobée d'une couche barrière 12 en SiOₓ), à une gravure sèche par exemple mise en oeuvre par un plasma d'oxygène ou par gravure ionique réactive (« RIE »), afin de structurer ces films internes 6 et 7 en enlevant leurs portions débordant de la couche barrière 12. Comme illustré à la figure 3 par des tirets P, est exposée à cette gravure sèche la totalité de la surface de l'unité pré-encapsulée et, comme visible à la figure 4, il résulte de cette gravure que ces films 6 et 7 sont structurés de sorte à être entièrement confinés en deçà du bord périphérique de la couche barrière 12, avant dépôt de l'encapsulation.

Avantageusement, la couche tampon 11 en Alq3 présente une épaisseur comprise entre 100 nm et 200 nm qui est par exemple proche de 100 nm (pour une émission verte). Quant à la couche barrière 12 en SiOₓ qui est déposée par évaporation thermique non réactive, elle présente une épaisseur par exemple comprise entre 5 nm et 50 nm.

Comme visible à la figure 16, on a apporté un soin particulier à l'élaboration du dépôt de la couche barrière 12 de SiOₓ puisqu'un masque pochoir de surface supérieure a été utilisé pour le dépôt de cette couche d'oxyde 12. On s'assure ainsi d'enrober entièrement le plot recouvert de la couche tampon 11 en Alq3 par cette couche 12 de silice évaporée. Sont également visibles à cette figure 16 la zone de dépôt de la cathode 10 et l'anneau de cathode 10a, en plus des zones de dépôt des couches 11 et 12.

On a illustré à la figure 17 les caractéristiques optiques de la couche 12 de SiOₓ déposée, mesurées par ellipsométrie. Ce SiOₓ déposé par évaporation thermique non réactive présente un indice optique moyen sur la gamme visible de 1,884 nm, et un indice optique à 500 nm de 1,892. Comparativement aux données de la littérature qui donnent un indice optique de SiO (x = 1) égal à 2 ± 0,03 à 500 nm et un indice optique d'un SiOₓ évaporé avec x proche de 2 compris entre 1,45 et 1,47, cet indice mesuré pour le SiOₓ de l'invention dénote clairement une stoechiométrie proche de 1 : 1, soit x sensiblement égal à 1.

La structure d'encapsulation 13, 14, 15 comprend une couche inorganique interne 13 de Al₂O₃ déposée par « ALD » et enveloppant la couche barrière 12 de SiOₓ (visible à la figure 4), et une couche polymérique photosensible 14 déposée en phase liquide qui enveloppe à son tour la couche inorganique 13 et qui est surmontée de manière enveloppante d'une couche inorganique externe 15 par exemple également constituée d'Al₂O₃ déposé par « ALD » (ces deux couches 14 et 15 sont visibles à la figure 5, qui montre par une zone en pointillés ces dépôts mutuellement enveloppants).

On dépose la couche polymérique 14, par exemple à base d'une résine positive de photolithographie de dénomination « TELR », en la déposant par exemple par enduction sur la couche inorganique interne 13, puis on la grave par insolation à des rayonnements UV à en la masquant sélectivement des rayonnements UV pour qu'elle soit polymérisée au-dessus de la couche inorganique interne 13 et en une portion enveloppante enrobant latéralement cette couche 13, et dépolymérisée ailleurs. On développe ensuite cette couche photosensible polymérisée par trempage dans un bain (e.g. dans un bain développeur de TMAH), et l'on réalise optionnellement une insolation complémentaire de la couche photosensible 14 finalement obtenue.

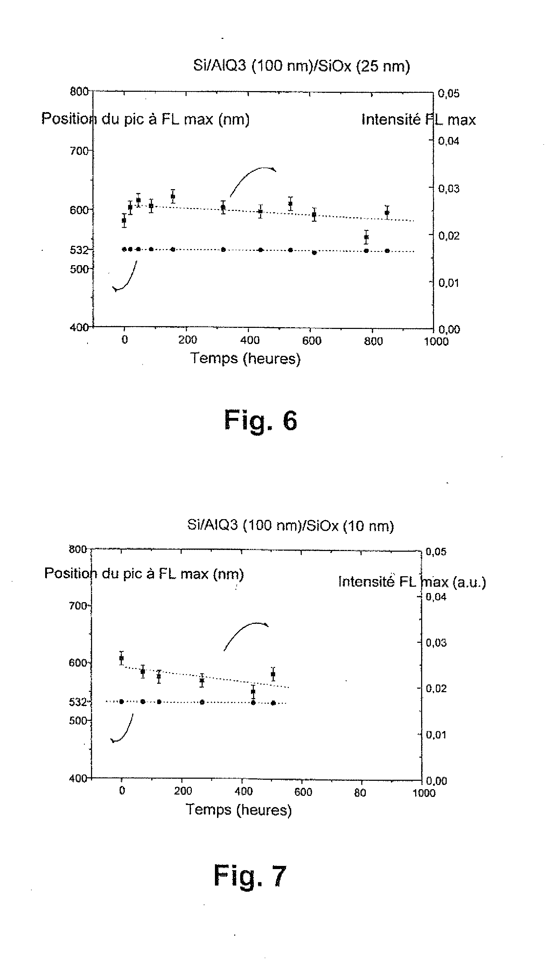

La Demanderesse a réalisé des essais, dont les résultats sont visibles aux figures 6 et 7, illustrant la qualité de l'encapsulation d'une couche tampon d'Alq3 de 100 nm d'épaisseur déposée sur silicium et enrobée d'une couche barrière de SiOₓ de 25 nm d'épaisseur et de 10 nm d'épaisseur, respectivement. Ces essais ont permis de montrer que la couche d'Alq3 de 100 nm d'épaisseur est encapsulée de manière robuste en chambre climatique par la couche de SiOₓ. Plus précisément, on a reporté sur ces graphiques la tenue de ces couches Alq3/ SiOₓ (à 65° C et 85 % de taux d'humidité relative HR). On a quantifié la tenue à l'étuve de ces deux couches en surveillant l'évolution, à partir de t₀, de la photoluminescence (FL) de la couche d'Alq3 (excitation en lumière UV à 365 nm, au microscope avec un grossissement x10 en intensité maximum de FL, et en position du pic à l'intensité maximale - émission verte à 532 nm pour Alq3 à l'état solide - versus le temps de stockage en chambre climatique). Les figures 6 et 7 montrent ainsi l'évolution à 65° C et 85 % RH de la FL (intensité maximale FL max et position du pic à intensité FL max) de films d'Alq3 de 100 nm déposés sur Si et encapsulés par SiOₓ.

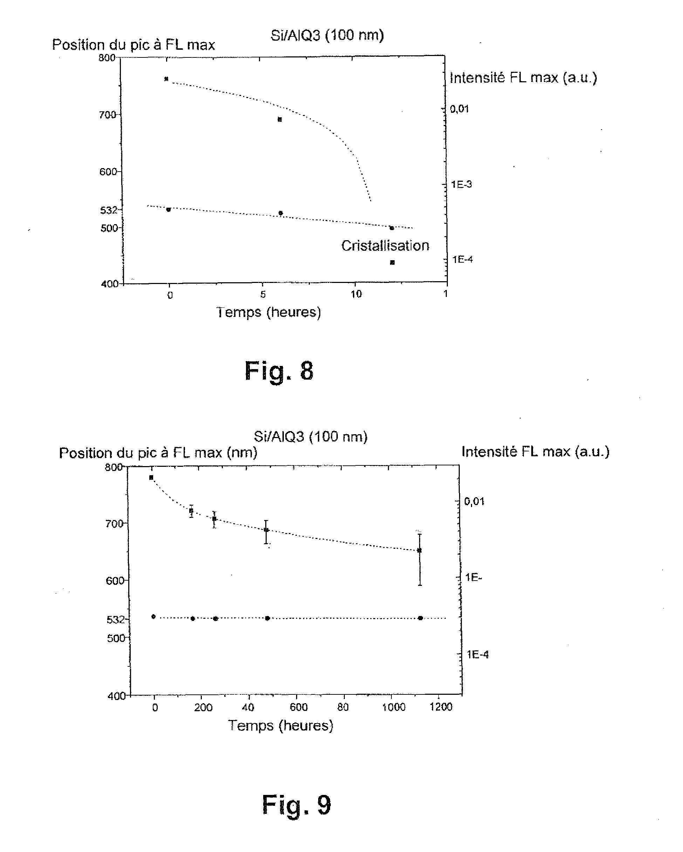

Pour comparaison, on a testé en outre la tenue d'un film d'Alq3 vierge en stockage en chambre climatique à 65° C / 85 % RH (figure 8) et à l'atmosphère du laboratoire (figure 9).

Il apparaît clairement au vu de l'ensemble de ces résultats que le film de SiOₓ apporte une protection importante au film d'Alq3 dont l'intensité de FL après environ 850 h de stockage n'a perdu qu'environ 10 % de sa valeur avec une encapsulation par 25 nm de SiOₓ, et n'a perdu qu'environ 17 % de sa valeur après environ 550 h avec une encapsulation par 10 nm de SiOₓ.

A l'opposé, le film non encapsulé et stocké à 65° C / 85 % RH (voir figure 8) voit son intensité de FL divisée par 300 après 12 h seulement en étuve. Cela s'accompagne clairement d'une cristallisation de la couche organométallique dont la position du pic de FL subit un « blue-shift » (i.e. décalage vers le bleu) à 496 nm après 12 h de stockage. Le film d'Alq3 vierge conservé à l'atmosphère du laboratoire (voir figure 9) montre quant à lui une diminution de l'intensité de FL d'un facteur d'environ 10 après environ 1200 h de stockage mais sans aucune cristallisation apparente.

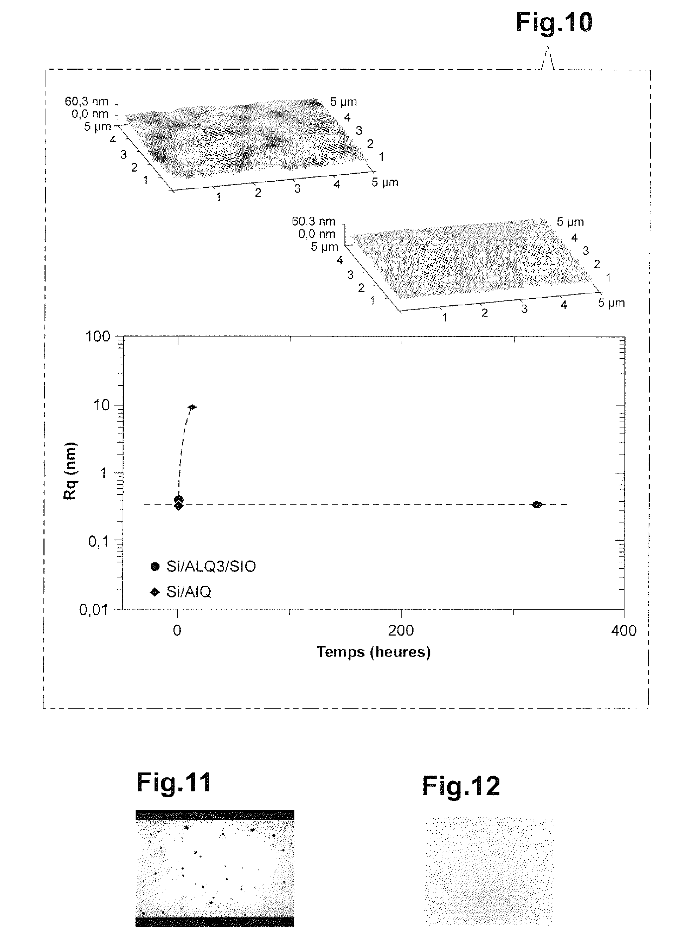

La figure 10 montre la surface (images au microscope à force atomique) d'un film témoin d'Alq3 vierge (de 100 nm d'épaisseur et dépourvu de film de SiOₓ) déposé sur silicium après 12h de stockage en chambre climatique (à 65° C et 85 % RH) ainsi que l'évolution de la rugosité de surface (Rq) en fonction du temps de stockage, en comparaison du même film d'Alq3 encapsulé selon l'invention par un film de SiOₓ. On constate que la rugosité du film d'Alq3/SiOₓ reste parfaitement stable - environ 0,3 nm - après plus de 350 h en étuve (image de droite surmontant le graphique) alors que la surface du film d'Alq3 non encapsulé montre une rugosité très importante d'environ 10 nm après 12 h de stockage (image de gauche).

La Demanderesse a également réalisé des mesures de densité de défauts dans la couche de SiOₓ en fonction des couches présentes sous cette couche de SiOₓ, mesures qui sont reportées au tableau 1 suivant :

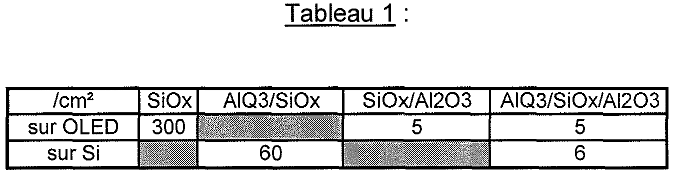

Concernant le dépôt sur « OLED », le SiOₓ a été déposé sur une cathode en argent (de 15 nm d'épaisseur).

Le comptage a été mené par observation des points noirs sur « OLED » (voir figure 11) et de zones surbrillantes clairement visibles pour les films déposés sur Si (voir figure 12). Chaque zone surbrillante et chaque point noir ont été comptabilisés comme un défaut, avec comme hypothèse qu'il n'y a pas de défauts non visibles au microscope optique. La figure 11 montre la surface d'une « OLED » utilisant une couche d'encapsulation de SiOₓ évaporée après plus de 840 h à l'atmosphère du laboratoire (sous 6 V, microscopie optique x 2,5, avec une densité défauts d'environ 300/cm²), et la figure 12 montre la surface d'une structure Si/Alq3/SiOₓ après plus de 536 h à 65° C et 85 % RH (par microscopie optique avec une image négative pour une meilleure observation montrant peu de zones surbrillantes pour les défauts, présents selon une densité d'environ 60/cm²).

Il en résulte que la densité de défauts dans SiOₓ semble beaucoup plus faible sur Alq3 que directement sur la cathode en argent de l'unité « OLED ». Le composé Alq3 apparaît donc très avantageux pour former une couche 11 à bonnes propriétés tampon afin de faire croître une couche barrière 12 de SiOₓ évaporé avec moins de défauts.

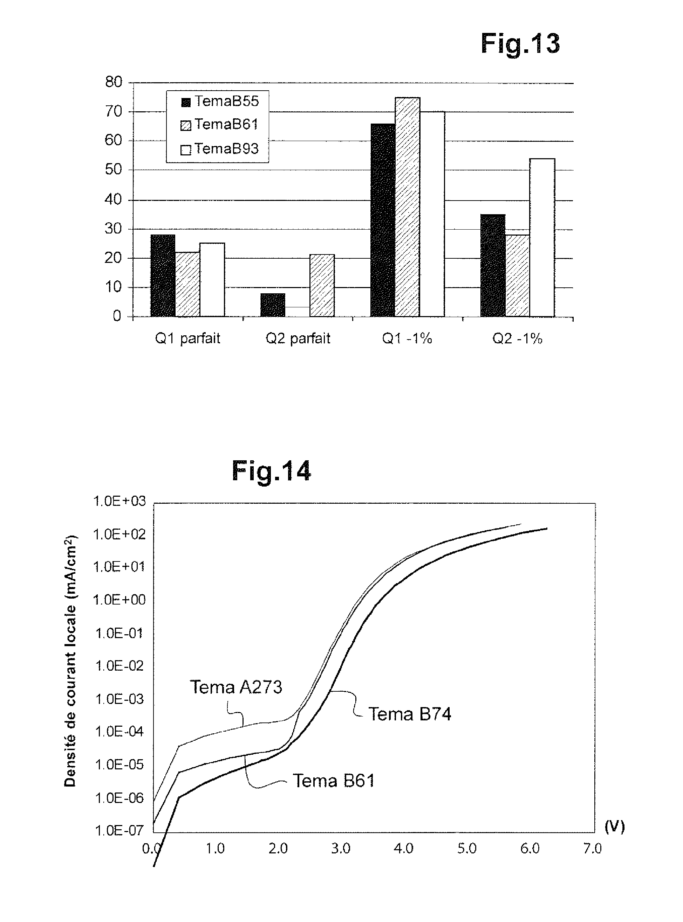

Les figures 13 à 15 illustrent notamment la possibilité de réaliser un traitement plasma (par exemple un plasma d'oxygène) sur la surface de l'unité « OLED » pré-encapsulée avant son encapsulation. Ce traitement va faciliter le dépôt « ALD » subséquent. Ceci peut être expliqué par le fait que ce traitement permet notamment de fonctionnaliser en -OH la surface totale du substrat 2 en vue d'y faire croître de manière satisfaisante par « ALD » une couche d'encapsulation 13 (typiquement d'Al₂O₃), mais sans dégrader les caractéristiques du dispositif qui sont sensibles à une atmosphère oxydante, notamment.

La Demanderesse a en effet démontré que l'utilisation de la pré-encapsulation Alq3/SiOₓ permet précisément de réaliser un tel traitement de surface par plasma O₂ avant le dépôt de la couche inorganique d'encapsulation d'Al₂O₃ 13 déposée par « ALD » (voir à nouveau la figure 2 commentée ci-dessous pour ce traitement plasma P), grâce à la protection conférée par cette pré-encapsulation à deux couches 11 et 12 jouant le rôle d'un masque dur. Il a même été possible de réaliser un transfert directement à l'air ambiant entre la sortie de l'enceinte de dépôt et la chambre plasma se trouvant dans l'atmosphère respirable de la salle blanche, sans dégrader l'unité « OLED » testée.

Le graphique de la figure 13 illustre le taux de diodes parfaites et -1 % (c'est-à-dire les diodes dont la surface défectueuse représente moins de 1 % de la surface totale de la diode), tant pour Q1 que Q2, après 200 h de stockage pour chacun des dispositifs « TemaB55 », « TemaB61 » et »TemaB93 » dont les caractéristiques sont recensées dans le tableau 2 ci-après.

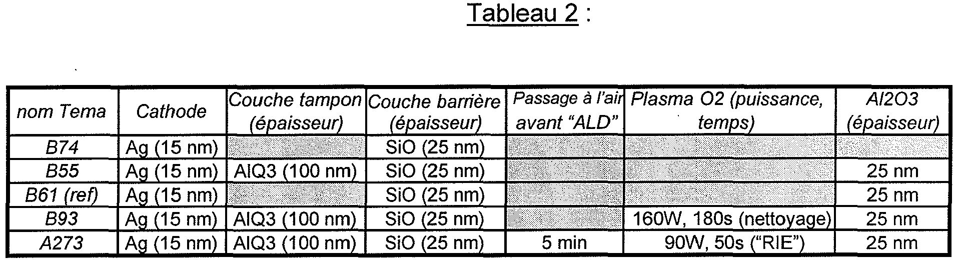

Il est important de noter ici que le plasma O₂ réalisé sur le niveau SiO de l'OLED ne donne pas naissance à des points noirs dans l'état initial. Au contraire, à t₀, les taux de Q2 (diodes matricées) parfaits sur « TemaB55 », « TemaB61 » et « TemaB93 » sont respectivement de 98 %, 68 % et 90 %. Pour les taux de Q1 (diodes planes), ces valeurs sont respectivement de 92 %, 62 % et 90 %. Sur la figure 13, on a comparé ces mêmes taux après 200 h. Il apparaît clairement sur les diodes Q2 une amélioration dès lors que le traitement plasma est effectué sur le SiOₓ avant le dépôt d'Al₂O₃.

Les trois courbes visibles sur le graphique de la figure 14 représentent les caractéristiques IV des diodes (Q2, t₀) «TemaA273 », « TemaB61 » et « TemaB74 », respectivement, et ces courbes montrent que les caractéristiques des diodes (Q2) ayant subi le passage à l'air puis le traitement plasma (i.e. « TemaA273 ») ne sont pas affectées en comparaison de la référence « TemaB61 ». De manière prévisible, la référence « TemaB74 » sans encapsulation Al₂O₃ subit une oxydation immédiate de sa cathode fine dès sa sortie à l'atmosphère respirable, menant inévitablement à un décalage important vers les tensions élevées, à courant fixé. En général, les diodes Q2 étant très sensibles à l'atmosphère, elles se dégradent très vite sur les dispositifs de type « TemaB74 » et n'émettent plus de lumière aux tensions usuelles de fonctionnement (V < 5 volts) après quelques jours.

On a évalué la durée de vie du dispositif « TemaA273 » selon l'invention, soumis au passage à l'air ambiant et au plasma O₂, puis on l'a comparée à celle du dispositif standard « TemaB61 » dans le but de vérifier que ces traitements successifs d'exposition à l'air et au plasma O₂ n'affectent pas la diode d'une quelconque manière. Le résultat est reporté sur la figure 15, dont les courbes montrent effectivement que la durée de vie (Q2, à courant constant et luminance initiale d'environ 1000 cd/m²) du dispositif « TemaA273 » n'est que peu modifiée par rapport à celle de cette référence.

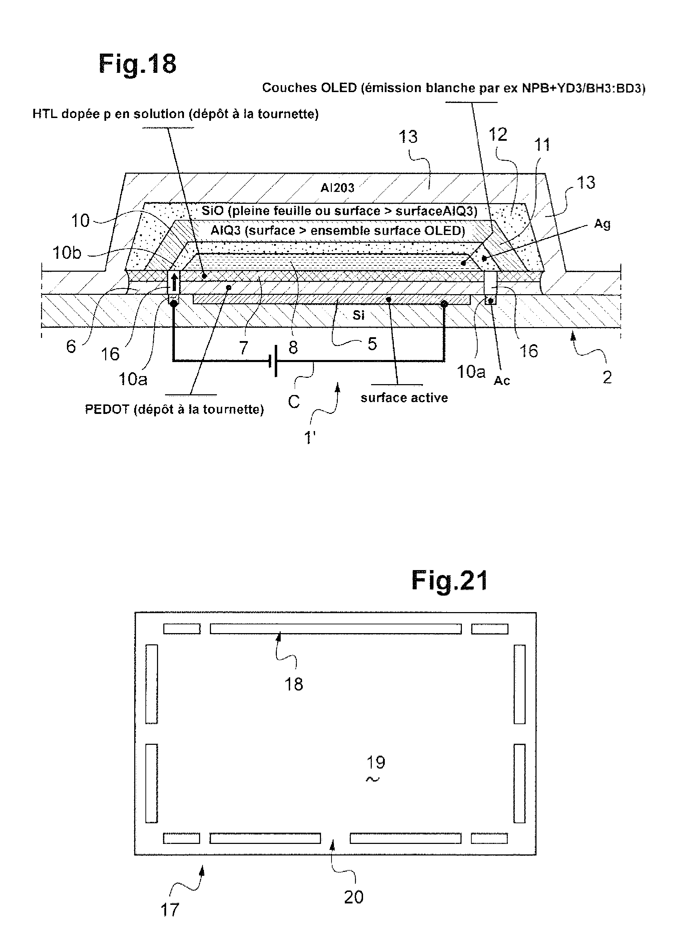

Le dispositif 1' selon la variante de la figure 18 se distingue uniquement de celui de la figure 4, en ce qu'est formé à travers les films organiques internes 6 et 7 déposés par voie liquide un canal annulaire 16 assurant la conduction électrique entre la cathode 10 et l'anneau de cathode 10a formant la piste de contact électrique avec l'anode 5 (le circuit électrique C reliant l'anode 5 à l'anneau de cathode 10a est illustré schématiquement à la figure 18).

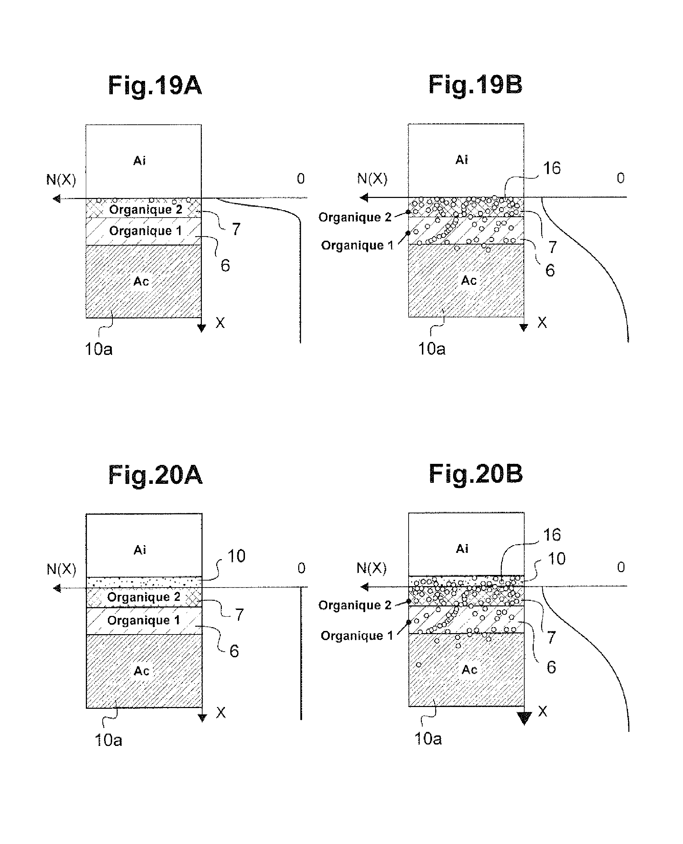

Le canal 16 est par exemple constitué d'atomes d'aluminium déposés par une technique « PVD » de pulvérisation locale à travers les films 6 et 7, au moyen d'un masque perforé 17 (« shadow mask » en anglais) tel que celui représenté schématiquement à la figure 21, de manière que ces atomes traversent ces films 6 et 7 avec au final une distribution suffisamment dense au contact du bord périphérique interne 10b de la cathode 10 surmontant les films 6, 7, 8 et de l'anneau de cathode 10a. Cette distribution selon l'invention est illustrée aux figures 19B et 20B commentées ci-après.

On voit dans l'exemple de la figure 21 que ce masque 17 génère des zones ouvertes 18 formées d'une ligne périphérique discontinue, et des zones fermées 19 et 20 comprenant un interstice 20 qui est ménagé deux zones ouvertes adjacentes 18 et qui permet le passage de la ligne électrique de contact avec l'anode 5.

On obtient ainsi le canal 16 en forme de film annulaire électriquement conducteur qui, grâce à cette technique de pulvérisation, pénètre les films 6 et 7 déposés par voie liquide qui sont relativement mous jusqu'à atteindre l'anneau de cathode 10a. La condensation des atomes d'aluminium d'énergie conséquente en pulvérisation permet leur pénétration ou « perçage » des films 6 et 7 sous-jacents. Il se forme alors une distribution de ces atomes métalliques dans ces films 6 et 7 autorisant un chemin de percolation pour les électrons et donc un contact électrique amélioré pour la diode.

La figure 19B illustre un premier exemple de réalisation de ce canal conducteur 16, selon lequel cette pulvérisation est réalisée directement sur l'empilement des deux films 6 et 7 déposés par voie liquide (i.e. avant le dépôt ultérieur de la cathode 10). On voit que la distribution N(x) dense et relativement homogène des atomes d'aluminium ayant pénétré les films 6 et 7 sous-jacents permet de créer ce canal 16, contrairement à la figure 19A où le dépôt d'aluminium par évaporation thermique ne permet pas d'obtenir une telle distribution pénétrante dans ces films 6 et 7.

La figure 20B illustre un second exemple de réalisation du canal conducteur 16, selon lequel la pulvérisation est réalisée directement sur la cathode 10 une fois celle-ci déposée sur l'empilement des films 6, 7, 8, laquelle cathode est choisie relativement fine (d'épaisseur inférieure à 20 nm et par exemple en argent). On voit que la distribution N(x) dense et relativement homogène des atomes d'aluminium ayant pénétré les films 6 et 7 déposés par voie liquide permet de créer ce canal 16, contrairement à la figure 20A où le dépôt d'aluminium par évaporation thermique ne permet pas d'obtenir une telle distribution pénétrante dans ces films 6 et 7.

## Revendications

1. Dispositif optoélectronique organique (1, 1'), tel qu'un micro-afficheur à diodes électroluminescentes organiques, ce dispositif comprenant :
- un substrat (2),
- au moins une unité électroluminescente déposée sur ce substrat et incorporant une électrode interne (5) adjacente au substrat, une électrode externe (10) transparente ou semi-transparente à la lumière émise par l'unité et définissant une zone active (4) d'émission lumineuse et, entre ces électrodes, un empilement de films organiques (6, 7, 8), et
- une structure d'encapsulation (13, 14, 15) étanche à couche(s) mince(s) qui comprend au moins une couche inorganique (13, 15) qui surmonte ladite unité électroluminescente en l'enveloppant latéralement,
ce dispositif comprenant en outre une structure de pré-encapsulation (12) qui est localisée entre l'électrode externe et la structure d'encapsulation et qui comprend une couche barrière (12) à base d'un oxyde de silicium de formule SiOₓ, avec x nombre réel tel que 0 < x < 2,
ce dispositif est tel que la ou chaque unité électroluminescente est de type hybride, du fait qu' au moins l'un des films actifs (6, 7) dudit empilement de films organiques qu'elle comporte, de préférence le(s) plus interne(s) formant par exemple au moins un film de transfert d'électrons (« ETL »), un film d'injection de trous (« HIL ») et/ou un film de transfert de trous (« HTL »), étant déposé par voie liquide sur tout le substrat (2), ce(s) film(s) actif(s) étant ensuite structuré(s) par une gravure sèche (P) de sorte que ce(s) film(s) structuré(s) (6, 7) se termine(nt) latéralement sensiblement au droit d'un bord périphérique de ladite couche barrière (12)
**caractérisé en ce que** la structure d'encapsulation comprend en outre une couche tampon (11) recouvrant l'électrode externe et à base d'au moins un complexe organométallique hétérocyclique de température de transition vitreuse supérieure à 80°C et **en ce que** la couche barrière (12) recouvre cette couche tampon.

2. Dispositif (1, 1') selon la revendication 1, **caractérisé en ce que** ladite structure de pré-encapsulation (11, 12) forme un masque dur apte à résister à ladite gravure sèche (P), par exemple mise en oeuvre par un plasma d'oxygène ou par gravure ionique réactive (« RIE »).

3. Dispositif (1') selon la revendication 1 ou 2, **caractérisé en ce qu'**il comporte des moyens de liaison (16) électriquement conducteurs qui relient directement un bord périphérique interne (10b) de l'électrode externe (10) à un contact électrique (10a) de cette dernière prévu dans ledit substrat (2), et qui traversent le(s)dit(s) film(s) actif(s) le(s) plus interne(s) (6 et 7) dudit empilement de films organiques déposé(s) par voie liquide.

4. Dispositif (1') selon la revendication 3, **caractérisé en ce que** lesdits moyens de liaison (16) forment un canal métallique annulaire, de préférence à base d'aluminium, sous la forme d'une distribution d'atomes métalliques (16) répartis à travers le(s)dit(s) film(s) actif(s) (6 et 7) jusqu'audit contact électrique (10a) en forme d'anneau et optionnellement en outre à travers l'électrode externe (10) qui est dans ce cas d'épaisseur inférieure à 20 nm.

5. Dispositif (1, 1') selon une des revendications précédentes, **caractérisé en ce que** ledit complexe organométallique de la couche tampon (11) est dérivé de la quinoléine ou de la benzoquinoléine et présente une température de transition vitreuse supérieure à 80° C, et de préférence **en ce que** ledit complexe organométallique est le tris-(8-hydroxyquinoléinate) d'aluminium III (Alq3).

6. Dispositif (1, 1') selon une des revendications précédentes, **caractérisé en ce que** ledit oxyde de silicium de formule SiOₓ de ladite couche barrière (12) est tel que x est sensiblement égal à 1, et **en ce que** cette couche barrière est déposée par évaporation thermique non réactive.

7. Dispositif (1, 1') selon une des revendications précédentes, **caractérisé en ce que** ladite couche tampon (11) présente une surface d'aire au moins égale à celle de ladite électrode externe (10), laquelle est de préférence constituée d'une cathode en argent, et **en ce que** ladite couche barrière (12) présente une surface d'aire au moins égale à celle de la couche tampon, et de préférence **en ce que** ladite couche barrière (12) déborde latéralement autour de ladite couche tampon (11) qui déborde latéralement autour de ladite électrode externe (10), lesdites couches tampon et barrière s'étendant toutes deux continûment à partir de films internes (6 et 7) dudit empilement de films organiques (6, 7, 8).

8. Dispositif (1, 1') selon une des revendications précédentes, **caractérisé en ce que** ladite structure d'encapsulation (13, 14, 15) comprend une couche inorganique, dite couche inorganique interne (13), qui est déposée sur ladite couche barrière de pré-encapsulation (12) par dépôt de couche atomique (« ALD ») ou par dépôt chimique en phase vapeur assisté par plasma (« PECVD »), qui est à base d'au moins un composé inorganique choisi dans le groupe constitué par les composés de formule AlₓO_{y}, SiOₓ, SiₓN_{y}, SiOₓN_{y}, ZnSe, Sb₂O₃ et les oxydes transparents conducteurs (OTC) optionnellement combinés à un métal, et qui est de préférence à base d'Al₂O₃ déposé par « ALD », cette couche inorganique interne s'étendant à partir du substrat (2) en enrobant latéralement ladite couche barrière (12) et plusieurs desdits films organiques (6 et 7) dudit empilement (6, 7, 8).

9. Dispositif (1) selon la revendication 8, **caractérisé en ce que** ladite structure d'encapsulation (13, 14, 15) comprend également :
- au moins une couche polymérique photosensible gravée (14) qui est de préférence à base d'une résine positive de photolithographie et qui recouvre ladite couche inorganique interne (13) de manière latéralement enveloppante en s'étendant à partir du substrat (2), et
- une autre couche inorganique, dite couche inorganique externe (15), qui est par exemple à base du même composé que ladite couche inorganique interne et qui recouvre de manière latéralement enveloppante cette couche polymérique photosensible, de sorte à former une pluralité de surfaces parallèles entre elles et sensiblement perpendiculaires au plan (3) du substrat qui forment autant d'obstacles à la pénétration latérale de vapeur d'eau vers ladite ou chaque zone active (4) du dispositif.

10. Procédé d'encapsulation d'un dispositif (1, 1') selon une des revendications précédentes, **caractérisé en ce qu'**il comprend les étapes successives suivantes :
a) on dépose ladite couche tampon (11) sur ladite électrode externe (10) de la ou de chaque unité électroluminescente, cette couche tampon étant de préférence à base d'un complexe organométallique dérivé de la quinoléine ou de la benzoquinoléine de température de transition vitreuse supérieure à 100° C tel que le tris-(8-hydroxyquinoléinate) d'aluminium III (Alq3),
b) on dépose par évaporation thermique non réactive ladite couche barrière (12) sur cette couche tampon, cette couche barrière étant à base d'un oxyde de formule SiOₓ avec de préférence x sensiblement égal à 1 et enrobant latéralement cette couche tampon,
c) on transfère optionnellement la ou chaque unité électroluminescente recouverte de ces couches tampon et barrière en vue de son encapsulation, directement à l'atmosphère ambiante sans la confiner dans une enceinte de transfert telle qu'une boîte à gants,
d) on soumet à une gravure sèche (P), par exemple mise en oeuvre par un plasma d'oxygène ou par gravure ionique réactive (« RIE »), la ou chaque unité électroluminescente recouverte de ces couches tampon et barrière (11 et 12), puis
e) on dépose sur cette couche barrière (12) la couche inorganique de ladite structure d'encapsulation (13, 14, 15), dite couche inorganique interne (13), par dépôt de couche atomique (« ALD ») ou par dépôt chimique en phase vapeur assisté par plasma (« PECVD »), cette couche inorganique interne étant à base d'au moins un composé inorganique choisi dans le groupe constitué par les composés de formule AlₓO_{y}, SiOₓ, SiₓN_{y}, SiOₓN_{y}, ZnSe, Sb₂O₃ et les oxydes transparents conducteurs (OTC) optionnellement combinés à un métal, et qui est de préférence à base d'Al₂O₃ déposé par « ALD », de telle sorte que cette couche inorganique interne s'étende à partir du substrat en enrobant latéralement la couche barrière et le(s)dit(s) films (s) le(s) plus interne(s) (6, 7) dudit empilement de films organiques.

11. Procédé selon la revendication 10, **caractérisé en ce que** l'étape d) est menée pour structurer l'un au moins des films actifs les plus internes (6, 7) dudit empilement (6, 7, 8) de films organiques de cette unité dans le cas où il a été déposé par voie liquide sur tout le substrat (2) de sorte qu'il se termine latéralement sensiblement au droit d'un bord périphérique de ladite couche barrière (12) par enlèvement de la portion dudit au moins un film (6, 7) dépassant latéralement de la couche barrière, ledit au moins un film ainsi structuré formant par exemple un film de transfert d'électrons (« ETL »), un film d'injection de trous (« HIL ») et/ou un film de transfert de trous (« HTL »), ces couches tampon et barrière jouant alors le rôle d'un masque dur lors de cette gravure.

12. Procédé selon la revendication 11, **caractérisé en ce qu'**il comprend avant l'étape a) un dépôt par pulvérisation localisée d'atomes métalliques (16) de préférence à base d'aluminium à travers le(s)dit(s) film(s) actif(s) le(s) plus interne(s) (6 et 7) préalablement déposé(s) par voie liquide, pour que ces atomes se répartissent à travers ce(s)dit(s) film(s) actif(s) en y formant un canal annulaire (16) électriquement conducteur reliant directement un bord périphérique interne (10b) de l'électrode externe (10) à un contact électrique (10a) de cette dernière prévu dans ledit substrat (2).

13. Procédé selon la revendication 12, **caractérisé en ce que** l'on réalise ce dépôt par pulvérisation localisée au moyen d'un masque perforé (17) pour que ledit canal (16) soit de forme annulaire comme ledit contact électrique (10a) de l'électrode externe (10), cette pulvérisation étant réalisée au choix :
- avant le dépôt de l'électrode externe, directement sur et à travers le(s)dit(s) film(s) actif(s) le(s) plus interne(s) (6 et 7) de l'empilement de films organiques déposé(s) par voie liquide, ou
- après le dépôt de l'électrode externe qui présente alors de préférence une épaisseur inférieure à 20 nm, directement sur et à travers cette électrode externe et ce(s) film(s) actif(s) le(s) plus interne(s) de l'empilement de films organique.

14. Procédé selon une des revendications 10 à 13, **caractérisé en ce qu'**il comprend en outre une étape f) consécutive à l'étape e) où :
f1) on dépose en phase liquide sur ladite couche inorganique interne (13) une couche photosensible (14) qui est par exemple à base d'une résine positive de photolithographie,
f2) on grave cette couche photosensible ainsi déposée par insolation à des emplacements prédéterminés en la masquant sélectivement des rayonnements d'insolation pour qu'elle soit, d'une part, polymérisée suite à cette insolation au-dessus de ladite couche inorganique interne et en une portion enveloppante enrobant latéralement cette couche inorganique interne à partir du substrat (2) et, d'autre part, dépolymérisée ailleurs, puis
f3) on développe cette couche photosensible polymérisée par trempage dans un bain, optionnellement suivi d'une insolation complémentaire de cette couche photosensible (14).

15. Procédé selon la revendication 14, **caractérisé en ce qu'**il comprend en outre une étape g) consécutive à l'étape f) où l'on dépose sur ladite couche polymérique photosensible (14) une autre couche inorganique, dite couche inorganique externe (15), qui est par exemple à base du même composé que ladite couche inorganique interne (13) et qui recouvre également de manière latéralement enveloppante cette couche polymérique photosensible, de sorte à former une pluralité de surfaces parallèles entre elles et sensiblement perpendiculaires au plan (3) du substrat (2) qui forment autant d'obstacles à la pénétration latérale de vapeur d'eau vers la ou chaque zone active (4) du dispositif (1).

## Patentansprüche

1. Organische optoelektronische Vorrichtung (1, 1'), wie ein Mikrodisplay aus organischen Leuchtdioden, wobei die Vorrichtung umfasst:
- ein Substrat (2),
- wenigstens eine elektrolumineszierende Einheit, die auf das Substrat aufgebracht ist und eine an dem Substrat anliegende innere Elektrode (5), eine äußere Elektrode (10), die für das von der Einheit emittierte Licht transparent oder semitransparent ist und eine aktive Lichtemissionszone (4) definiert, und, zwischen diesen Elektroden, einen Stapel organischer Filme (6, 7, 8) einschließt, und
- eine wasserdichte Dünnschichtverkapselungsstruktur (13, 14, 15), die wenigstens eine anorganische Schicht (13, 15) umfasst, die auf der elektrolumineszierenden Einheit platziert ist und diese seitlich umhüllt,
wobei die Vorrichtung weiterhin eine Vorverkapselungstruktur (12) umfasst, die sich zwischen der äußeren Elektrode und der Verkapselungsstruktur befindet und die eine Barriereschicht (12) auf Basis eines Siliciumoxids der Formel SiOₓ umfasst, wobei x eine reele Zahl ist, so dass 0 < x < 2 ist,
wobei die Vorrichtung derart ist, dass die oder jede elektrolumineszierende Einheit vom Hybridtyp ist, indem wenigstens einer der aktiven Filme (6, 7) des Stapels organischer Filme, den sie umfasst, bevorzugt der oder die innerste(n), die beispielsweise wenigstens einen Elektronentransportfilm ("ETL"), einen Lochinjektionsfilm ("HIL") und/oder einen Lochtransportfilm ("HTL") bilden, auf flüssigem Wege auf dem ganzen Substrat (2) aufgebracht ist, und der oder die aktive(n) Film(e) anschließend durch Trockenätzen strukturiert sind, so dass der oder die strukturierte(n) Film(e) (6, 7) seitlich im Wesentlichen rechtwinklig zu eine peripheren Rand der Barriereschicht (12) enden,
**dadurch gekennzeichnet, dass** die Verkapselungsstruktur weiterhin eine Pufferschicht (11) umfasst, die die äußere Elektrode bedeckt und auf wenigstens einem heterocyclischen metallorganischen Komplex mit einer Glasübergangstemperatur über 80°C basiert, und dadurch, dass die Barriereschicht (12) die Pufferschicht bedeckt.

2. Vorrichtung (1, 1') nach Anspruch 1, **dadurch gekennzeichnet, dass** die Vorverkapselungsstruktur (11, 12) eine Hartmaske bildet, die geeignet ist, dem Trockenätzen (P), das beispielsweise durch Sauerstoffplasma oder durch reaktives lonenätzen ("RIE") erfolgt, standzuhalten.

3. Vorrichtung (1') nach Anspruch 1 oder 2, **dadurch gekennzeichnet, dass** sie elektrisch leitende Verbindungsmittel (16) umfasst, die einen inneren peripheren Rand (10b) der äußeren Elektrode (10) direkt mit einem in dem Substrat (2) vorgesehenen elektrischen Kontakt (10a) von letzterer verbinden, und die durch den oder die innersten, auf flüssigem Wege aufgebrachten aktiven Film(e) (6, 7) des Stapels organischer Filme verlaufen.

4. Vorrichtung (1') nach Anspruch 3, **dadurch gekennzeichnet, dass** die Verbindungsmittel (16) einen ringförmigen metallischen Kanal bilden, bevorzugt auf Aluminiumbasis, in Form einer Verteilung von Metallatomen (16), die in Form eines Rings durch den oder die aktiven Film(e) (6 und 7) bis zu dem elektrischen Kontakt (10a) und wahlweise weiterhin durch die äußere Elektrode verteilt sind, die in diesem Fall eine Dicke von weniger als 20 nm hat.

5. Vorrichtung (1, 1') nach einem der vorhergehenden Ansprüche, **dadurch gekennzeichnet, dass** sich der metallorganische Komplex der Pufferschicht (11) von Chinolin oder Benzochinolin ableitet und eine Glasübergangstemperatur über 80 °C aufweist, und bevorzugt dadurch, dass der metallorganische Komplex Aluminium-tris-(8-hydroxychinolin) (Alq3) ist.

6. Vorrichtung (1, 1') nach einem der vorhergehenden Ansprüche, **dadurch gekennzeichnet, dass** das Siliciumoxid der Formel SiOₓ der Barriereschicht (12) derart ist, dass x im Wesentlichen gleich 1 ist, und dadurch, dass die Barriereschicht durch nichtreaktives thermisches Aufdampfen aufgebracht ist.

7. Vorrichtung (1, 1') nach einem der vorhergehenden Ansprüche, **dadurch gekennzeichnet, dass** die Pufferschicht (11) eine Oberfläche aufweist, die wenigstens gleich der der äußeren Elektrode (10) ist, die bevorzugt eine Sifberkathode ist, und dadurch, dass die Barriereschicht (12) eine Oberfläche aufweist, die wenigstens gleich der der Pufferschicht ist, und bevorzugt dadurch, dass sich die Barriereschicht (12) seitlich um und über die Pufferschicht (11) erstreckt, die sich seitlich um und über die äußere Elektrode (10) erstreckt, wobei sich die Pufferschicht und die Barriereschicht beide kontinuierlich von inneren Filmen (6 und 7) des Stapels organischer Filme (6, 7, 8) ab erstrecken.

8. Vorrichtung (1, 1') nach einem der vorhergehenden Ansprüche, **dadurch gekennzeichnet, dass** die Verkapselungsstruktur (13, 14, 15) eine anorganische Schicht, innere anorganische Schicht (13) genannt, umfasst, die durch Atomlagenabscheidung ("ALD") oder plasmaunterstützte chemische Gasphasenabscheidung ("PECVD") auf die Vorverkapselungsbarriereschicht (12) aufgebracht ist, die auf wenigstens einer anorganischen Verbindung basiert, die ausgewählt ist aus der Gruppe bestehend aus den Verbindungen der Formel AlₓO_{y}, SiOₓ, SiₓN_{y}, SiOₓN_{y}, ZnSe, Sb₂O₃ und wahlweise mit einem Metall kombinierten transparenten leitfähigen Oxiden ("OTC"), und die bevorzugt auf durch "ALD" aufgebrachtem Al₂O₃ basiert, wobei sich die innere anorganische Schicht vom Substrat (2) ab erstreckt und die Barriereschicht (12) und eine Mehrzahl der organischen Filme (6 und 7) des Stapels (6, 7, 8) seitlich ummantelt.

9. Vorrichtung (1) nach Anspruch 8, **dadurch gekennzeichnet, dass** die Verkapselungsstruktur (13, 14, 15) weiterhin umfasst:
- wenigstens eine geätzte lichtempfindliche Polymerschicht (14), die bevorzugt auf einem positiven photolithographischen Harz basiert und die die innere anorganische Schicht (13) in seitlich umhüllender Weise bedeckt, indem sie sich vom Substrat (2) ab erstreckt, und
- eine andere anorganische Schicht, äußere anorganische Schicht (15) genannt, die beispielsweise auf der gleichen Verbindung wie die innere anorganische Schicht basiert und die die lichtempfindliche Polymerschicht in seitlich umhüllender Weise bedeckt, so dass eine Mehrzahl zueinander paralleler und im Wesentlichen zur Ebene (3) des Substrats senkrechter Oberflächen gebildet wird, die ebenso viele Sperren gegen das seitliche Eindringen von Wasserdampf hin zu der oder jeder aktiven Zone (4) der Vorrichtung bilden.

10. Verfahren zur Verkapselung einer Vorrichtung (1, 1') nach einem der vorhergehenden Ansprüche, **dadurch gekennzeichnet, dass** es die folgenden aufeinanderfolgenden Schritte umfasst:
a) die Pufferschicht (11) wird auf die äußere Elektrode (10) von der oder jeder elektrolumineszierenden Einheit aufgebracht, wobei die Pufferschicht bevorzugt auf einem metallorganische Komplex basiert, der sich von Chinolin oder Benzochinolin mit einer Glasübergangstemperatur über 100 °C ableitet, wie Aluminium-tris-(8-hydroxychinolin) (Alq3),
b) die Barriereschicht (12) wird durch nichtreaktives thermisches Aufdampfen auf die Pufferschicht aufgebracht, wobei die Barriereschicht auf einem Siliciumoxid der Formel SiOₓ mit x bevorzugt im Wesentlichen gleich 1 basiert und die Pufferschicht seitlich ummantelt,
c) wahlweise wird die oder jede elektrolumineszierende Einheit, die im Hinblick auf die Verkapselung mit der Pufferschicht und der Barriereschicht bedeckt ist, direkt ohne sie in ein Gehäuse zur Überführung wie einen Handschuhkasten einzuschließen in die Umgebungsatmosphäre überführt,
d) die oder jede elektrolumineszierende Einheit, die mit der Pufferschicht und der Barriereschicht (11 und 12) bedeckt ist, wird einer Trockenätzung (P) unterzogen, die beispielsweise durch Sauerstoffplasma oder durch reaktives Ionenätzen ("RIE") erfolgt, und anschließend wird
e) die anorganische Schicht der Verkapselungsstruktur (13, 14, 15), innere anorganische Schicht (13) genannt, durch Atomlagenabscheidung ("ALD") oder plasmaunterstützte chemische Gasphasenabscheidung ("PECVD") auf die Barriereschicht (12) aufgebracht, wobei die innere anorganische Schicht auf wenigstens einer anorganischen Verbindung basiert, die ausgewählt ist aus der Gruppe bestehend aus den Verbindungen der Formel AlₓO_{y}, SiOₓ, SiₓN_{y}, SiOₓN_{y}, ZnSe, Sb₂O₃ und wahlweise mit einem Metall kombinierten transparenten leitfähigen Oxiden ("OTC"), und die bevorzugt auf durch "ALD" aufgebrachtem Al₂O₃ basiert, so dass sich die innere anorganische Schicht von dem Substrat erstreckt und die Barriereschicht (12) und den oder die innersten Film(e) (6 und 7) des Stapels (6, 7, 8) organischer Filme seitlich umhüllt.

11. Verfahren nach Anspruch 10, **dadurch gekennzeichnet, dass** Schritt d) durchgeführt wird, um wenigstens einen der innersten aktiven Filme (6, 7) des Stapels organischer Filme (6, 7, 8) dieser Einheit in dem Fall zu strukturieren, wo er auf flüssigem Wege auf das ganze Substrat (2) aufgebracht wurde, so dass er durch Entfernen des Teils des wenigstens einen Films (6, 7), der seitlich über die Barriereschicht hinausragt, seitlich im Wesentlichen rechtwinklig zu einem peripheren Rand der Barriereschicht (12) endet, wobei der wenigstens eine so strukturierte Film beispielsweise einen Elektronentransportfilm ("ETL"), einen Lochinjektionsfilm ("HIL") und/oder einen Lochtransportfilm ("HTL") bilden, wobei die Pufferschicht und die Barriereschicht dann die Rolle einer Hartmaske beim Ätzen spielen.

12. Verfahren nach Anspruch 11, **dadurch gekennzeichnet, dass** es vor Schritt a) eine Abscheidung von Metallatomen (16), bevorzugt auf Basis von Aluminium, durch lokalisiertes Aufsprühen durch den oder die zuvor auf flüssigem Wege aufgebrachten innersten aktiven Film(e) (6 und 7) umfasst, so dass sich die Atome durch den oder die aktiven Filme verteilen und dort einen elektrisch leitenden ringförmigen Kanal (16) bilden, der einen inneren peripheren Rand (10b) der äußeren Elektrode (10) direkt mit einem in dem Substrat (2) vorgesehenen elektrischen Kontakt (10a) von letzterer verbindet.

13. Verfahren nach Anspruch 12, **dadurch gekennzeichnet, dass** das Abscheiden durch lokalisiertes Aufsprühen mittels einer perforierten Maske (17) erfolgt, um dem Kanal (16) eine Ringform wie die des elektrischen Kontakts (10a) der äußeren Elektrode (10) zu geben, wobei das Aufsprühen wahlweise durchgeführt wird:
- vor dem Aufbringen der äußeren Elektrode direkt auf und durch den oder die auf flüssigem Wege aufgebrachten innersten aktiven Film(e) (6 und 7) des Stapels organischer Filme, oder
- nach dem Aufbringen der äußeren Elektrode, die dann bevorzugt eine Dicke von weniger als 20 nm hat, direkt auf und durch die äußere Elektrode und den oder die innersten aktiven Film(e) (6 und 7) des Stapels organischer Filme.

14. Verfahren nach einem der Ansprüche 10 bis 13, **dadurch gekennzeichnet, dass** es weiterhin einen auf Schritt e) folgenden Schritt f) umfasst, in dem:
f1) auf der inneren anorganischen Schicht (13) in Flüssigphase eine lichtempfindliche Schicht (14) aufgebracht wird, die beispielsweise auf einem positiven photolithographischen Harz basiert,
f2) die so aufgebrachte lichtempfindliche Schicht durch Bestrahlung an vorbestimmten Punkten geätzt wird, indem sie selektiv für die einfallende Strahlung maskiert wird, so dass sie einerseits als Folge der Bestrahlung oberhalb der inneren anorganischen Schicht und in einem umhüllenden Teil, der die innere anorganische Schicht vom Substrat (2) ab seitlich ummantelt, und andererseits an anderer Stelle depolymerisiert ist, und anschließend
f3) die lichtempfindliche polymerisierte Schicht durch Eintauchen in ein Bad entwickelt wird, wahlweise gefolgt von einer ergänzenden Bestrahlung der lichtempfindlichen Schicht (14).

15. Verfahren nach Anspruch 14, **dadurch gekennzeichnet, dass** es weiterhin einen auf Schritt f) folgenden Schritt g) umfasst, in dem auf die lichtempfindliche Polymerschicht (14) eine andere anorganische Schicht, äußere anorganische Schicht (15) genannt, aufgebracht wird, die beispielsweise auf der gleichen Verbindung wie die innere anorganische Schicht (13) basiert und die die lichtempfindliche Polymerschicht ebenfalls in seitlich umhüllender Weise bedeckt, so dass eine Mehrzahl zueinander paralleler und im Wesentlichen zur Ebene (3) des Substrats (2) senkrechter Oberflächen gebildet wird, die ebenso viele Sperren gegen das seitliche Eindringen von Wasserdampf hin zu der oder jeder aktiven Zone (4) der Vorrichtung (1) bilden.

## Claims

1. An organic optoelectronic device (1, 1'), such as a micro-display having organic light-emitting diodes, this device comprising:
- a substrate (2),
- at least one electroluminescent unit deposited on this substrate and incorporating an internal electrode (5) adjacent to the substrate, an external electrode (10) which is transparent or semi-transparent to the light emitted by the unit and which defines an active light emission zone (4), and a stack of organic films (6, 7, 8) between these electrodes, and
- a thin-layer encapsulation structure (13, 14, 15) which comprises at least one inorganic layer (13, 15) which is placed on top of said electroluminescent unit and encases it laterally,
this device further comprising a pre-encapsulation structure (12) which is located between the external electrode and the encapsulation structure and which comprises a barrier layer (12) based on a silicon oxide of formula SiOₓ, where x is a real number such that 0 < x < 2,
this device is such that the or each electroluminescent unit is of the hybrid type because at least one of the active films (6, 7) of said stack of organic films that it includes, preferably the innermost film or films, forming for example at least an electron transport film (ETL), a hole injection film (HIL) and/or a hole transport film (HTL), being deposited by a liquid route over the whole substrate (2), this (these) active film(s) being then structured by a dry etching (P) such that this structured film or films (6, 7) terminate laterally substantially at right angles to a peripheral edge of said barrier layer (12),
**characterized in that** the pre-encapsulation structure further comprises a buffer layer (11) covering the external electrode and based on at least one heterocyclic organometallic complex with a glass transition temperature above 80°C and **in that** the barrier layer (12) covers this buffer layer.

2. The device (1, 1') as claimed in claim 1, **characterized in that** said pre-encapsulation structure (11, 12) forms a hard mask adapted to resist said dry etching (P), which is carried out, for example, by means of an oxygen plasma or by reactive ion etching (RIE).

3. The device (1') as claimed in claim 1 or 2, **characterized in that** it comprises electrically conductive connecting means (16) which directly link an inner peripheral edge (10b) of the external electrode (10) to an electrical contact (10a) of the latter provided in said substrate (2), and which pass through said innermost active film or films (6 and 7) of said stack of organic films which have been deposited by a liquid route.

4. The device (1') as claimed in claim 3, **characterized in that** said connecting means (16) form an annular metallic channel, preferably aluminum based, in the form of a distribution of metal atoms (16) which are spread through said active film or films (6 and 7) as far as said electrical contact (10a) in the shape of a ring, and optionally additionally through the external electrode (10) which in this case has a thickness of less than 20 nm.

5. The device (1, 1') as claimed in any of the preceding claims, **characterized in that** said organometallic complex of the buffer layer (11) is a quinoline or benzoquinoléine derivative and has a glass transition temperature above 80°C, and preferably **in that** said organometallic complex is tris(8-hydroxyquinolinato)aluminum (III) (Alq3).

6. The device (1, 1') as claimed in any of the preceding claims, **characterized in that** said silicon oxide with the formula SiOₓ of said barrier layer (12) is such that x is substantially equal to 1, and **in that** this barrier layer is deposited by non-reactive thermal evaporation.

7. The device (1, 1') as claimed in any of the preceding claims, **characterized in that** said buffer layer (11) has a surface area at least equal to that of said external electrode (10), which preferably consists of a silver cathode, and **in that** said barrier layer (12) has a surface area at least equal to that of the buffer layer, and preferably **in that** said barrier layer (12) extends laterally around and beyond said buffer layer (11) which extends laterally around and beyond said external electrode (10), both of said buffer and barrier layers extending continuously from interval films (6 and 7) of said stack of organic films (6, 7, 8).

8. The device (1, 1') as claimed in any of the preceding claims, **characterized in that** said encapsulation structure (13, 14, 15) comprises an inorganic layer, called inner inorganic layer (13), which is deposited on said pre-encapsulation barrier layer (12) by atomic layer deposition (ALD) or by plasma-assisted chemical vapor phase deposition (PECVD), which is based on at least one inorganic compound chosen from the groupe formed by compounds with the formulae AlₓO_{y}, SiOₓ, SiₓN_{y}, SiOₓN_{y}, ZnSe, Sb₂O₃ and transparent conductive oxides (TCOs) optionally combined with a metal, and which is preferably based on Al₂O₃ deposited by ALD, this inner inorganic layer extending from the substrate (2) and laterally coating said barrier layer (12) and a plurality of said organic films (6 and 7) of said stack (6, 7, 8).

9. The device (1) as claimed in claim 8, **characterized in that** said encapsulation structure (13, 14, 15) further comprises:
- at least one etched photosensitive polymer layer (14) which is preferably based on a positive photolithographic resin and which covers said inner inorganic layer (13) in a laterally encasing manner by extending from the substrate (2), and
- another inorganic layer, called outer inorganic layer (15), which is for example based on the same compound as said inner inorganic layer, and which covers this photosensitive polymer layer in a laterally encasing manner, so as to form a plurality of surfaces, parallel to each other and substantially perpendicular to the plane (3) of the substrate, which surfaces form the same number of obstacles to the lateral penetration of water vapor toward said active area or each active area (4) of the device.

10. A method for the encapsulation of a device (1, 1') as claimed in any of the preceding claims, **characterized in that** it comprises the following successive steps:
a) said buffer layer (11) is deposited on said external electrode (10) of the electroluminescent unit or of each electroluminescent unit, the buffer layer being preferably based on an organometallic complex derived from quinoline or benzoquinoline with a glass transition temperature above 100°C, such as tris(8-hydroxyquinolinato)aluminum (III) (Alq3),
b) said barrier layer (12) is deposited by non-reactive thermal evaporation on this buffer layer, this barrier layer being based on an oxide with the formula SiOₓ, where x is preferably substantially equal to 1, and laterally coating the buffer layer,
c) optionally, the electroluminescent unit, or each electroluminescent unit, covered with these buffer and barrier layers for its encapsulation, is transferred directly to the ambient atmosphere without being confined in a transfer enclosure such as a glove box,
d) the electroluminescent unit, or each electroluminescent unit, covered with these buffer and barrier layers (11 and 12), is subjected to dry etching (P), carried out for example by means of an oxygen plasma or by reactive ion etching (RIE), and then
e) the inorganic layer of said encapsulation structure (13, 14, 15), called inner inorganic layer (13), is deposited on the barrier layer (12) by atomic layer deposition (ALD) or by plasma-assisted chemical vapor phase deposition (PECVD), this inner inorganic layer being based on at least one inorganic compound chosen from the groupe formed by compounds with the formulae AlₓO_{y}, SiOₓ SiₓN_{y}, SiOₓN_{y}, ZnSe, Sb₂O₃ and transparent conductive oxides (TCOs) optionally combined with a metal, and preferably being based on Al₂O₃ deposited by ALD, in such a way that this inner inorganic layer extends from the substrate, thereby laterally coating the barrier layer and said innermost film or films (6, 7) of said stack of organic films.

11. The method as claimed in claim 10, **characterized in that** step d) is carried out in order to structure at least one of the innermost active films (6, 7) of said stack (6, 7, 8) of organic films of this unit, in the case where it has been deposited by a liquid route over the whole substrate (2), so that it terminates laterally substantially at right angles to a peripheral edge of said barrier layer (12), by removal of the portion of said at least one film (6, 7) which extends laterally beyond the barrier layer, said at least one structured film forming, for example, an electron transport film (ETL), a hole injection film (HIL) and/or a hole transport film (HTL), these buffer and barrier layers then acting as a hard mask during the etching.

12. The method as claimed in claim 11, **characterized in that** it comprises, before step a), deposition by localized spraying of metal atoms (16), preferably aluminium based, through said innermost active film or films (6 and 7) which have been deposited previously by a liquid route, so that these atoms are distributed through said active film or films, thus forming therein an electrically conductive annular channel (16) which directly connects an inner peripheral edge (10b)) of the external electrode (10) to an electrical contact (10a) of the latter provided in said substrate (2).

13. The method as claimed in claim 12, **characterized in that** this deposition is carried out by localized spraying by means of a perforated mask (17), in order to give said channel (16) an annular shape like that of said electrical contact (10a) of the external electrode (10), this spraying being carried out, according to choice, either
- before the deposition of the external electrode, directly onto and through said innermost active film or films (6 and 7) of the stack of organic films deposited by a liquid route, or
- after the deposition of the external electrode, which in this case preferably has a thickness of less than 20 nm, directly onto and through this external electrode and the innermost active film or films of the stack of organic films.

14. The method as claimed in any of claims 10 to 13, **characterized in that** it further comprises a step f), following step e), in which:
f1) a photosensitive layer (14), based for example on a positive photolithographic resin, is deposited in liquid phase onto said inner inorganic layer (13),
f2) this photosensitive layer, deposited in this way, is etched by irradiation at predetermined points by selectively masking the incident radiation so that the layer is polymerized as a result of this irradiation above said inner inorganic layer and in an enveloping portion which originates from the substrate (2) and laterally coats this inner inorganic layer, and is depolymerized elsewhere, after which
f3) this polymerized photosensitive layer is developed by immersion in a bath, optionally followed by supplementary irradiation of this photosensitive layer (14).

15. The method as claimed in claim 14, **characterized in that** it further comprises a step g), following step f), in which another inorganic layer, called outer inorganic layer (15), which is for example based on the same compound as said inner inorganic layer (13), is deposited onto said photosensitive polymer layer (14) and which also covers this photosensitive polymer layer in a laterally encasing manner, so as to form a plurality of surfaces, parallel to each other and substantially perpendicular to the plane (3) of the substrate (2), which surfaces form respective obstacles to the lateral penetration of water vapor toward the active area or each active area (4) of the device (1).
